# EUROPEAN PATENT APPLICATION

(11) **EP 4 138 120 A1**
(43) Date of publication of application: **22.02.2023**
(21) Application number: 22187607.1
(22) Date of filing: 28.07.2022
(51) Int. Cl.: H01L 21/50, H01L 23/04, H01L 23/00

(54) **LIDDED SEMICONDUCTOR PACKAGE**

(30) Priority: 18.08.2021 US 202163234270 P; 25.07.2022 US 202217872005
(71) Applicant: MediaTek Inc., Hsin-Chu 300 (TW)
(72) Inventor: TSAI, Yi-Lin, 30078 Hsinchu City (TW); LIN, Yi-Jou, 30078 Hsinchu City (TW); LAI, Tsai-Ming, 30078 Hsinchu City (TW); CHANG, Wei-Chen, 30078 Hsinchu City (TW)
(74) Representative: Hoefer & Partner Patentanwälte mbB

(57) **Abstract**

A semiconductor package (1) includes a substrate (100) having a top surface (100a) and a bottom surface (100b); a semiconductor die (110) mounted on the top surface (100a) of the substrate (100); and a two-part lid (300) mounted on a perimeter of the top surface (100a) of the substrate (100) and housing the semiconductor die (110). The two-part lid (300) comprises an annular lid base (310) and a cover plate (320) removably installed on the annular lid base (310).

## Description

### Cross Reference to Related Applications

This application claims the benefit of U.S. Provisional Application No. 63/234,270, filed on August 18th, 2021. The content of the application is incorporated herein by reference.

### Background

The present disclosure relates generally to the field of semiconductor packaging. More particularly, the present disclosure relates to a lidded semiconductor package with good warpage and SMT control as well as enhanced thermal performance.

A typical semiconductor package includes a semiconductor die mounted on an electrical connection substrate. A lid or a stiffener ring is mounted on the substrate on the same side as the die. The lid completely encloses the semiconductor die, which is positioned beneath it. A thermal interface material such as silicone or epoxy may be positioned between the die and the lid. The thermal interface material facilitates heat flow between the semiconductor die and the lid.

Compared to the semiconductor package with the stiffener ring, the lidded semiconductor package provides better warpage and SMT control. On the other hand, the semiconductor package with the stiffener ring has better thermal performance and heat-dissipating efficiency because a heat sink can be adhered directly onto the bare die.

### Summary

One object of the present invention is to provide a lidded semiconductor package having a detachable cover plate in order to solve the above-mentioned prior art problems or shortcomings. A semiconductor package according to the invention is defined in independent claim 1. The dependent claims define preferred embodiments thereof.

One aspect of the invention provides a semiconductor package includes a substrate having a top surface and a bottom surface; a semiconductor die mounted on the top surface of the substrate; and a two-part lid mounted on a perimeter of the top surface of the substrate and housing the semiconductor die. The two-part lid comprises an annular lid base and a cover plate removably installed on the annular lid base.

Preferably, the semiconductor die is mounted on the top surface of the substrate in a flip-chip manner.

Preferably, the semiconductor die has an active surface that faces downwardly to the substrate and connecting elements disposed on the active surface, wherein the connecting elements are bonded to respective pads disposed on the top surface of the substrate.

Preferably, a gap between the semiconductor die and the substrate is filled with an underfill layer.

Preferably, the two-part lid is a meal lid.

Preferably, the cover plate is arranged in a movable relationship with the annular lid base by using a sliding mechanism.

Preferably, the sliding mechanism is structured between the annular lid base and the cover plate such that the cover plate is movable relative to the annular lid base.

Preferably, the annular lid base comprises vertical inner walls spaced apart from the semiconductor die and vertical outer walls opposite to the vertical inner walls.

Preferably, the sliding grooves are provided on the vertical outer walls, wherein the sliding grooves and mating tongues of the cover plate are structured to cooperate in a manner that permits the cover plate to slide along the sliding grooves relative to the annular lid base.

Preferably, the cover plate is moved to a position along a sliding direction by sliding along the sliding grooves until an integral stopping member of the cover plate is in direct contact with the annular lid base.

Preferably, the annular lid base and the cover plate are constructed of stainless steel, aluminum, copper, platinum, nickel or an alloy thereof.

According to another aspect of the invention, an electronic device includes a base, and a semiconductor package, mounted on the base. The semiconductor package comprises a substrate having a top surface and a bottom surface, a semiconductor die mounted on the top surface of the substrate, and a two-part lid mounted on a perimeter of the top surface of the substrate and housing the semiconductor die. The two-part lid comprises an annular lid base and a cover plate removably installed on the annular lid base.

Preferably, the base comprises an application board or a system board.

Preferably, the semiconductor die is mounted on the top surface of the substrate in a flip-chip manner.

Preferably, the semiconductor die has an active surface that faces downwardly to the substrate and connecting elements disposed on the active surface. The connecting elements are bonded to respective pads disposed on the top surface of the substrate.

Preferably, a gap between the semiconductor die and the substrate is filled with an underfill layer.

Preferably, the two-part lid is a meal lid.

Preferably, the cover plate is arranged in a movable relationship with the annular lid base by using a sliding mechanism.

Preferably, the sliding mechanism is structured between the annular lid base and the cover plate such that the cover plate is movable relative to the annular lid base.

Preferably, the annular lid base comprises vertical inner walls spaced apart from the semiconductor die and vertical outer walls opposite to the vertical inner walls.

Preferably, sliding grooves are provided on the vertical outer walls, wherein the sliding grooves and mating tongues of the cover plate are structured to cooperate in a manner that permits the cover plate to slide along the sliding grooves relative to the annular lid base.

Preferably, the cover plate is moved to a position along a sliding direction by sliding along the sliding grooves until an integral stopping member of the cover plate is in direct contact with the annular lid base.

Preferably, the annular lid base and the cover plate are constructed of stainless steel, aluminum, copper, platinum, nickel or an alloy thereof.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing a lidded semiconductor package according to an embodiment of the present invention;
FIG. 2 and FIG. 3 are side views of the two-part lid in FIG. 1;
FIG. 4 is a diagram illustrating a state where the cover plate horizontally slides along a sliding direction; and
FIG. 5 is a schematic, cross-sectional diagram showing an electronic device according to an embodiment of the present invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

Packaging of an integrated circuit (IC) chip can involve attaching the IC chip to a substrate (e.g., a packaging substrate) which, among other things, provides mechanical support and electrical connections between the chip and other electronic components of a device. Substrate types include, for example, cored substrates, including thin core, thick core (laminate BT (bismaleimide-triazine resin) or FR-4 type fibrous board material), and laminate core, as well as coreless substrates. Cored package substrates, for example, can be built up layer by layer around a central core, with layers of conductive material (usually copper) separated by layers of insulating dielectric, with interlayer connections being formed with through holes or microvias (vias).

Thermal design and material selection continues to be a concern for electronic packages, particularly for flip chip ball grid array packages (FCBGA). Larger die sizes exhibit greater package warpage due to the difference in thermal expansion coefficients between silicon and laminate materials. As a result, large die packages are more difficult to solder mount and may produce larger variations in the bond line thickness between the die and external heat sinks.

The present disclosure pertains to a lidded semiconductor package having a two-part lid including a cover plate removably installed onto a lid base. After mounting the lidded semiconductor package onto a circuit board, the cover plate can be removed and a heat sink or a cooling module can be installed. The heat sink may be in direct contact with a surface of a bare die, thereby improving the thermal performance.

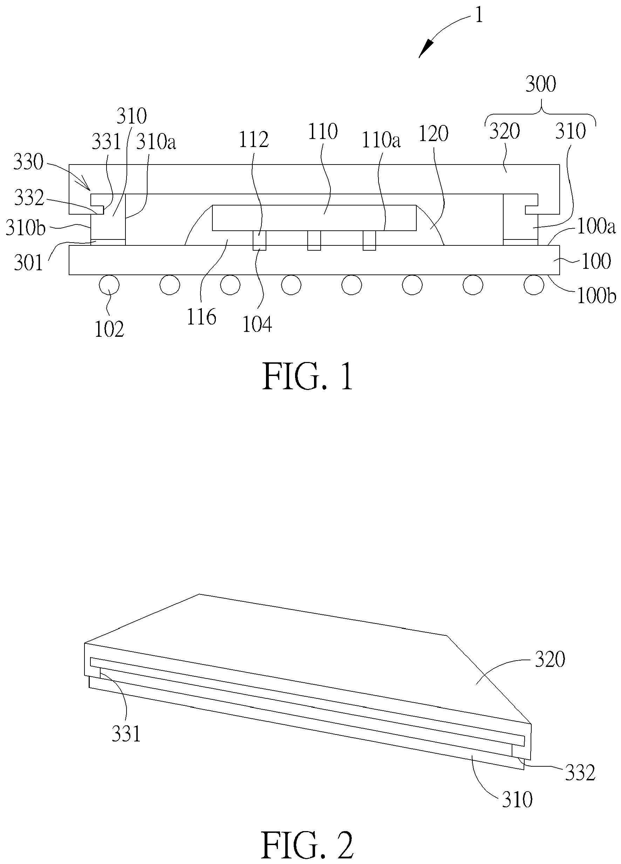

FIG. 1 is a schematic, cross-sectional diagram showing an exemplary lidded semiconductor package according to an embodiment of the invention. As shown in FIG. 1, the lidded semiconductor package 1 comprises a substrate 100 such as a package substrate or an interposer substrate, but not limited thereto. For the sake of simplicity, the traces or interconnect structures in the substrate 100 are not shown. It is understood that the substrate 100 may comprise circuits, traces and/or interconnect structures for electrically connecting the semiconductor die 110 to an external circuit system such as a printed circuit board (PCB) or a system board. Preferably, solder balls 102 such as BGA balls are disposed on the bottom surface 100b of the substrate 100.

Preferably, a semiconductor die (or a bare die) 110 may be mounted on a top surface 100a of the substrate 100, for example, in a flip-chip manner. The semiconductor die 110 has an active surface 110a that faces downwardly to the substrate 100. Connecting elements 112 such as conductive bumps, micro bumps, pillars or the like may be provided on the active surface 110a. The connecting elements 112 are bonded to respective pads 104 disposed on the top surface 100a of the substrate 100.

A gap 116 between the semiconductor die 110 and the substrate 100 may be filled with an underfill layer 120 comprising insulating material such as epoxy, but not limited thereto. For example, an underfill resin with a coefficient of thermal expansion (CTE) close to that of the connecting elements 112 may be deposited and cured in the gap between the semiconductor die 110 and substrate 100. The use of underfill resin enables structural coupling of the chip and substrate, effectively decreasing the shear stress and thus lowering the applied strain on the solder joints.

Preferably, a two-part lid 300 is secured onto a perimeter of the top surface 100a of the substrate 100 with an adhesive layer 301. Preferably, the two-part lid 300 may comprise stainless steel, aluminum, copper, platinum, nickel or an alloy thereof, but is not limited thereto. The semiconductor die 110 is housed by the two-part lid 300. The two-part lid 300 serves as physical protection for the semiconductor die 110 as well as package stiffener to alleviate package warpage during assembly process. Preferably, the two-part lid 300 comprises an annular lid base 310 and a cover plate 320 that is arranged in a movable relationship with the annular lid base 310. Preferably, the cover plate 320 is spaced the appropriate distance above the semiconductor die 110. Preferably, the cover plate 320 is not in direct contact with the semiconductor die 110.

Preferably, the annular lid base 310 comprises vertical inner walls 310a spaced apart from the semiconductor die 110 and vertical outer walls 310b opposite to the vertical inner walls 310a. A sliding mechanism 330 is structured between the annular lid base 310 and the cover plate 320 such that the cover plate 320 is movable relative to the annular lid base 310. For example, sliding grooves (or rails) 331 may be provided on the vertical outer walls 310b. The sliding grooves 331 and mating tongues 332 of the cover plate 320 are structured to cooperate in a manner that permits the sliding cover plate 320 to slide along the sliding grooves 331 relative to the annular lid base 310.

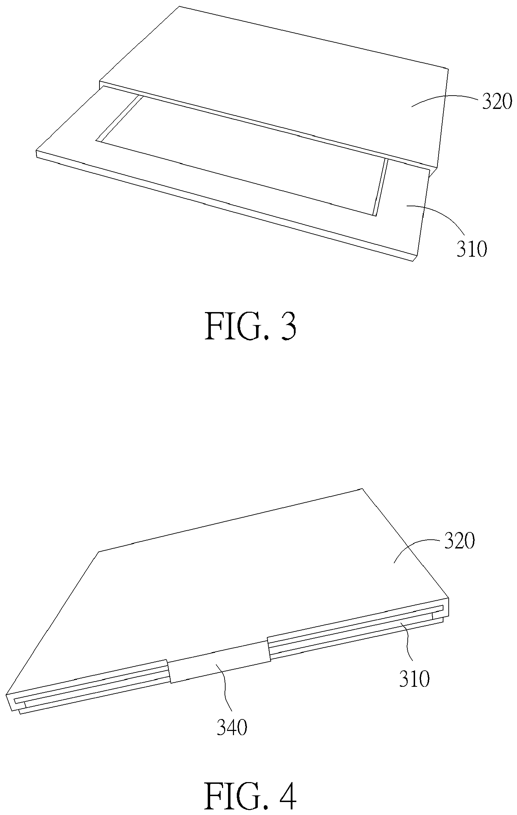

FIG. 2 and FIG. 3 are side views of the two-part lid 300 in FIG. 1. As shown in FIG. 2 and FIG. 3, the cover plate 320 may be moved to a position along a sliding direction by sliding along the sliding grooves 331 until an integral stopping member 340 of the cover plate 320 is in direct contact with the annular lid base 310. Preferably, the annular lid base 310 and the cover plate 320 are both constructed of substantially rigid material, such as metal or any suitable material.

Preferably, the sliding of the cover plate 320 is carried out through the use of the sliding groove 331 formed in the vertical outer walls 310b of the annular lid base 310. FIG. 4 is a diagram illustrating a state where the cover plate horizontally slides along a reversed sliding direction. As shown in FIG. 1 and FIG. 4, the cover plate 320 is detachable from the annular lid base 310 by continuous sliding of the cover plate 320 along the sliding grooves 331 until the mating tongues 332 disengage from the sliding grooves 331. The cover plate 320 is replaceable on the annular lid base 310 by re-engaging the tongues 332 with the sliding grooves 331 and sliding the cover plate 320 into position over the annular lid base 310. Preferably, the cover plate 320 may be removed after the surface mount or SMT process is completed, and a heat sink (not shown) may be mounted onto the semiconductor die 110.

It is advantageous to use the present invention because when assembling the lidded semiconductor package onto a printed circuit board (PCB), the two-part lid ensures good warpage control, thereby enhancing the reliability of the SMT process. After the SMT process, the cover plate of the two-part lid can be removed and can be replaced with a heat sink or a cooling module to improve the thermal performance of the semiconductor die.

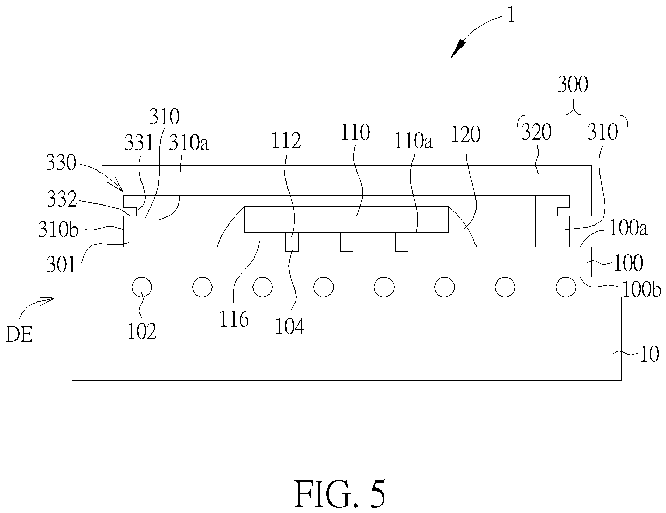

FIG. 5 is a schematic, cross-sectional diagram showing an electronic device according to an embodiment of the present invention. As shown in FIG. 5, an electronic device DE includes a base 10 such as an application board or a system board and a semiconductor package 1 mounted on the base 10. The semiconductor package 1 comprises a substrate 100 having a top surface 100a and a bottom surface 100b. A semiconductor die 110 is mounted on the top surface 100a of the substrate 100. A two-part lid 300 is mounted on a perimeter of the top surface 100a of the substrate 100. The two-part lid 300 houses the semiconductor die 110.

As shown in FIG. 2 to FIG. 4, the two-part lid 300 comprises an annular lid base 310 and a cover plate 320 removably installed on the annular lid base 310. The cover plate 320 may be moved to a position along a sliding direction by sliding along the sliding grooves 331 until an integral stopping member 340 of the cover plate 320 is in direct contact with the annular lid base 310. Preferably, the annular lid base 310 and the cover plate 320 are both constructed of substantially rigid material, such as metal or any suitable material.

Preferably, the sliding of the cover plate 320 is carried out through the use of the sliding groove 331 formed in the vertical outer walls 310b of the annular lid base 310. FIG. 4 is a diagram illustrating a state where the cover plate horizontally slides along a reversed sliding direction. As shown in FIG. 1 and FIG. 4, the cover plate 320 is detachable from the annular lid base 310 by continuous sliding of the cover plate 320 along the sliding grooves 331 until the mating tongues 332 disengage from the sliding grooves 331. The cover plate 320 is replaceable on the annular lid base 310 by re-engaging the tongues 332 with the sliding grooves 331 and sliding the cover plate 320 into position over the annular lid base 310. Preferably, the cover plate 320 may be removed after the surface mount or SMT process is completed, and a heat sink (not shown) may be mounted onto the semiconductor die 110.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (1), comprising:
a substrate (100) having a top surface (100a) and a bottom surface (100b);
a semiconductor die (110) mounted on the top surface (100a) of the substrate (100); and
a two-part lid (300) mounted on a perimeter of the top surface (100a) of the substrate (100) and housing the semiconductor die (110), wherein the two-part lid (300) comprises an annular lid base (310) and a cover plate (320) removably installed on the annular lid base (310).

2. The semiconductor package (1) according to claim 1, wherein the semiconductor die (110) is mounted on the top surface (100a) of the substrate (100) in a flip-chip manner.

3. The semiconductor package (1) according to claim 1 or 2, wherein the semiconductor die (110) has an active surface (110a) that faces downwardly to the substrate (100) and connecting elements (112) disposed on the active surface (110a), wherein the connecting elements (112) are bonded to respective pads (104) disposed on the top surface (100a) of the substrate (100).

4. The semiconductor package (1) according to any one of claims 1 to 3, wherein a gap (116) between the semiconductor die (110) and the substrate (100) is filled with an underfill layer (120).

5. The semiconductor package (1) according to any one of claims 1 to 4, wherein the two-part lid (300) is a metal lid.

6. The semiconductor package (1) according to any one of claims 1 to 5, wherein the cover plate (320) is arranged in a movable relationship with the annular lid base (310) by using a sliding mechanism (330).

7. The semiconductor package (1) according to claim 6, wherein the sliding mechanism (330) is structured between the annular lid base (310) and the cover plate (320) such that the cover plate (320) is movable relative to the annular lid base (310).

8. The semiconductor package (1) according to any one of claims 1 to 7, wherein the annular lid base (310) comprises vertical inner walls (310a) spaced apart from the semiconductor die (110) and vertical outer walls (310b) opposite to the vertical inner walls (310a).

9. The semiconductor package (1) according to claim 8, wherein sliding grooves (331) are provided on the vertical outer walls (310b), wherein the sliding grooves (331) and mating tongues (332) of the cover plate (320) are structured to cooperate in a manner that permits the cover plate (320) to slide along the sliding grooves (331) relative to the annular lid base (310).

10. The semiconductor package (1) according to claim 9, wherein the cover plate (320) is moved to a position along a sliding direction by sliding along the sliding grooves (331) until an integral stopping member (340) of the cover plate (320) is in direct contact with the annular lid base (310).

11. The semiconductor package (1) according to any one of claims 1 to 10, wherein the annular lid base (310) and the cover plate (320) are constructed of stainless steel, aluminum, copper, platinum, nickel or an alloy thereof.

12. An electronic device (DE), comprising:
a base (10); and
a semiconductor package (1) according to any one of the preceding claims, mounted on the base (10).

13. The electronic device (DE) according to claim 12, wherein the base (10) comprises an application board or a system board.
